# EUROPEAN PATENT APPLICATION

(11) **EP 4 539 111 A1**
(43) Date of publication of application: **16.04.2025**
(21) Application number: 22945131.5
(22) Date of filing: 10.06.2022
(51) Int. Cl.: H01L 21/52

(54) **PRODUCT HOLDING DEVICE, PRODUCT HOLDING METHOD, AND SEMICONDUCTOR DEVICE PRODUCTION APPARATUS**

(71) Applicant: Yamaha Robotics Holdings., Ltd., Tokyo 208-8585 (JP); TOKYO UNIVERSITY OF SCIENCE FOUNDATION, Tokyo 162-8601 (JP)
(72) Inventor: KIKUCHI, Hiroshi, Musashimurayama-shi, Tokyo 208-8585 (JP); LI, Jin, Musashimurayama-shi, Tokyo 208-8585 (JP); MUNAKATA, Hiroshi, Musashimurayama-shi, Tokyo 208-8585 (JP); NAGATA, Norimasa, Musashimurayama-shi, Tokyo 208-8585 (JP); MIYATAKE, Masaaki, Tokyo 162-8601 (JP)
(74) Representative: Becker, Eberhard
(86) International application number: PCT/JP2022/023482
(87) International publication number: WO 2023/238393

(57) **Abstract**

This product holding device comprises: a stage (32) on which a product is to be placed; and vibration elements (38) that apply ultrasonic vibrations to the product (100) placed on the stage (32), and causes falling foreign matter (110) to float at a location away from the surface of the product (100). In addition, the product holding device (30) further comprises: a transport mechanism (42) that transports the floating foreign matter (110) to a location that is outside the product (100) in a plan view; and a collection mechanism (50) that collects the transported foreign matter (110).

## Description

### Technical Field

The specification discloses a product holding apparatus mounting and holding a product on a stage, a product holding method, and a semiconductor device production apparatus having the product holding apparatus.

### Related Art

In precision equipment, such as a semiconductor device, it is required that no foreign matter is attached to the product during the production process and the storage period. However, at the time of exerting a predetermined process to the product to produce the product, a tool for exerting such process moves, and, together with the movement of the tool, fine foreign matters may fall onto and be attached to the surface of the product. In addition, during a period when the product is temporary stored, fine foreign matters floating in the storage space may also fall onto and be attached to the surface of the product.

Therefore, conventionally, a technique of using ultrasonic waves for removing a foreign matter attached to the surface of the product has been proposed. However, since a force of a certain level is required in order to separate and remove the foreign matter once attached to the product from the product, even if ultrasonic waves are used, it is still difficult to separate and remove the foreign matter from the product, and it is common that foreign matters remain on the product. In addition, in the conventional technique, in order to remove the attached foreign matter, a specialized process is required, and the production process of the product becomes complicated, making the takt time increase.

Therefore, in some solutions, a technique has been proposed so that a foreign matter is not attached onto the surface of the product. For example, Patent Document 1 discloses a technique in which a dust collection electrode is provided on the periphery of a sample, and the dust collection electrode is applied with a voltage higher than and having the same polarity with the voltage applied to the sample. Accordingly, most foreign matters, such as particles, flying by being attracted by the electric field can be captured by the dust collection electrode. As a result, the attachment of foreign matters onto the surface of the sample can be prevented to a certain degree.

### [Prior Art Document(s)]

### [Patent Document(s)]

Patent Document 1: Japanese Laid-open No. 2016-106374

### SUMMARY OF INVENTION

### Technical Problem

However, in Patent Document 1, the dust collection electrode is provided only on the periphery of the sample. Therefore, when the size of the sample increases and the distance from the center of the sample to the dust collection electrode increases, a foreign matter falling onto the vicinity of the center of the sample cannot be captured by the dust collection electrode. Thus, conventionally, a technique that can effectively prevent a sedimentary foreign matter from being attached to the surface of the product is yet to be provided.

Therefore, the specification discloses a product holding device capable of more reliably preventing a sedimentary foreign matter from being attached to the product, a product holding method, and a semiconductor device production apparatus.

### Solution to Problem

A product holding device disclosed in the specification includes: a stage, on which a product is mounted; a vibration source, applying ultrasonic vibration to the product mounted on the stage and causing a falling foreign matter to float at a location away from a surface of the product.

In such case, the product holding device may further include: a transport mechanism, transporting the floating foreign matter to a location on an outer side of the product in a plan view.

In addition, the transport mechanism may include at least one of a blower for compressing air and a suction machine for sucking air.

In addition, the transport mechanism may include an ultrasonic source outputting traveling waves of ultrasonic waves in a direction substantially parallel to the surface of the product.

In addition, the transport mechanism may include an ultrasonic source and a reflective plate arranged to face each other by sandwiching the product, and the transport mechanism may form a standing wave field by using ultrasonic waves formed between the ultrasonic source and the reflective plate and transport the foreign matter in the standing wave field by moving a node of a sound pressure.

In addition, the product holding device may include a recovery mechanism, collecting the foreign matter transported to the outer side of the product by using the movement mechanism.

The recovery mechanism may include at least one of a suction machine, an adhesive body, and an electric dust collector, the suction machine may suck and collect the foreign matter transported to the outer side of the product by using the movement mechanism, the adhesive body may adhere and hold the foreign matter, and the electric dust collector may collect the foreign matter by using a Coulomb force.

According to a product holding method in the specification, in a state in which a product is mounted on a stage, ultrasonic vibration is applied to the product to cause a falling foreign matter to float at a location away from a surface of the product.

A semiconductor device production apparatus disclosed in the specification is a semiconductor device production apparatus that mounts a chip on a substrate to produce a semiconductor device. The semiconductor device production apparatus includes the product holding device. At least one of the substrate and the chip is held, as the product, by using the product holding device.

In such case, the semiconductor device production apparatus may further include a controller. The controller may intermittently drive the vibration source in accordance with a progress of a mounting process of the chip.

In such case, the controller may temporarily stop driving of the vibration source at at least one of a locating timing of adjusting a location of a mounting head with respect to the substrate, a timing immediately before and after a chip held by the mounting head lands on the substrate, and a timing of confirming locating accuracy of the chip that is mounted.

### Effects of Invention

According to the technique disclosed in the specification, a sedimentary foreign matter can be reliably prevented from being attached to the product.

### BRIEF DESCRIPTION OF DRAWINGS

[FIG. 1] FIG. 1 is a schematic view illustrating a configuration of a production apparatus.
[FIG. 2] FIG. 2 is a schematic view illustrating the vicinity of the surface of a product.
[FIG. 3] FIG. 3 is a view illustrating another example of a transfer mechanism and a recovery mechanism.
[FIG. 4] FIG. 4 is a view illustrating another example of a transfer mechanism and a recovery mechanism.
[FIG. 5] FIG. 5 is a view illustrating another example of a transfer mechanism and a recovery mechanism.
[FIG. 6] FIG. 6 is a flowchart illustrating a flow of producing a semiconductor device.

### DESCRIPTION OF EMBODIMENTS

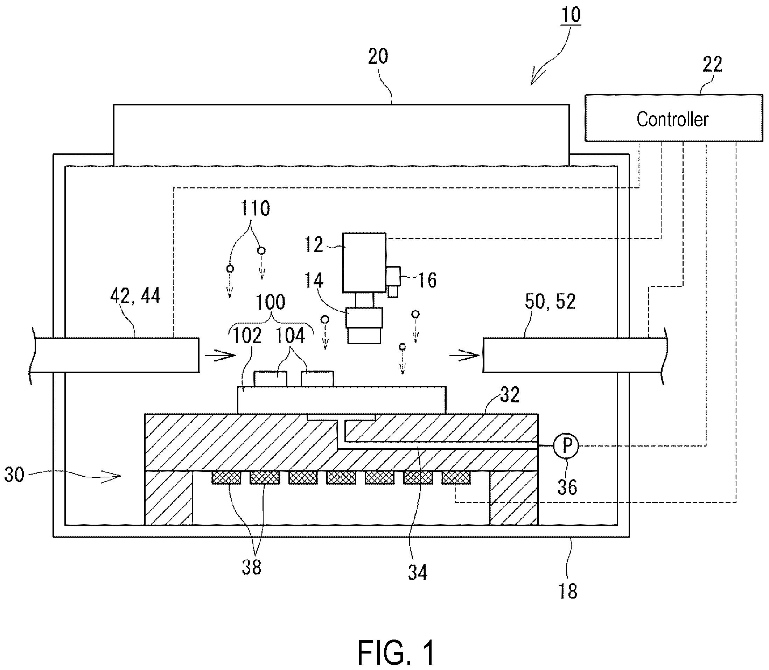

In the following, with reference to the drawings, the configuration of a production apparatus 10 having a holding device 30 is described. FIG. 1 is a schematic view illustrating a configuration of the production apparatus 10. The production apparatus 10 produces a semiconductor device by mounting one or more chip 104 onto a substrate 102. The production apparatus 10 has a bonding head 12, the holding device 30, and a controller 22 controlling driving of the bonding head 12 and the holding device 30. The bonding head 12 and the holding device 30 are disposed in an enclosed space inside a chamber 18. In the chamber 18, a fan filter unit (referred to as "FFU" in the following) 20 is provided to ensure the cleanliness of the air inside the chamber 18. The FFU 20 is a unit formed by combining a fan for delivering air into the chamber 18 and a filter for removing foreign matters from the air.

The bonding head 12 bonds the chip 104 to the substrate 102. Through bonding, an electrode provided on the bottom surface of the chip 104 is attached to and electrically connected with an electrode provided on the upper surface of the substrate 102. In the example, the properties of metal atoms are used, and the electrodes are attached under room temperature. However, it goes without saying that the disclosure is not limited to the attachment under room temperature, and bonding in other forms may also be performed. For example, the chip 104 may be heated to weld the electrodes.

The bonding head 12 moves in the horizontal direction and the upper-lower direction. In addition, the bonding head 12 has a holding tool 14 that attracts and holds the chip 104. At the time of bonding the chip 104 to a target surface, the chip 104 held by the bonding tool 14 is brought into contact with the substrate 102 and bonded under room temperature.

The bonding head 12 is further provided with a locating camera 16 for imaging the substrate 102. The controller 22 to be described afterwards, based on the image imaged by the locating camera 16, specifies the location of the bonding head 12 with respect to the substrate 102 and locates the bonding head 12.

The holding device 30 holds the product 100 in the middle of production. More specifically, the holding device 30 holds the substrate 102. As described above, one or more chips 104 are bonded to the upper surface of the substrate 102. The holding device 30 has a stage 32. The substrate 102 is mounted on the upper surface of the stage 32. In addition, a suction hole 34 in communication with the upper surface of the stage 32 is formed in the stage 32. A suction pump 36 is in communication with the suction hole 34, and, through the driving of the suction pump 36, the substrate 102 is sucked and held to the stage 32.

The holding device 30 of the embodiment further includes a vibration element 38, a transfer mechanism 42, and a recovery mechanism 50. The vibration element 38 serves as a vibration source that exerts ultrasonic vibration to the product 100 via the stage 32. Multiple vibration elements 38 are provided on the bottom surface of the stage 32, for example. The vibration elements 38 may be synchronized and driven at the same time, and may also be driven independently. Each vibration element 38 receives a driving signal that is a voltage signal, and is a vibration generation source that generates vertical vibration. The vibration element 38 has, for example, Pb zirconate titanate (commonly known as PZT) that vibrates when applied with an AC voltage, and is a bolt-fastened Langevin type transducer (commonly known as a BLT or BL transducer) in which the PZT is sandwiched between metal blocks and a fastening pressure is applied through screwing with a screw (bolt).

The transport mechanism 42 transports a foreign matter 110 floating on the upper side of the product 100 to a location on the outer side of the product 100 in a plan view. The configuration of the transport mechanism 42 is not particularly limited as long as such mechanism can transport the foreign matter 110. However, the transport mechanism 42 of the embodiment has a blower nozzle 44 that delivers air in a direction substantially parallel to the surface of the product 100.

The recovery mechanism 50 collects the foreign matters 110 transported to the outer side of the product 100. The configuration of the recovery mechanism 50 is not particularly limited, either. However, the recovery mechanism 50 of the embodiment includes a suction nozzle 52 sucking and collecting the foreign matters 110.

The controller 22 controls the driving of the production apparatus 10. Specifically, the controller 22 controls moving of the bonding head 12, and causes the bonding head 12 to execute bonding of the chip 104 to the substrate 102. In addition, the controller 22 drives the vibration elements 38, the transport mechanism 42, and the recovery mechanism 50 in parallel to the bonding process, thereby preventing the foreign matters 110 from being attached to the surface of the product 100. The controller 22 is a computer physically having a processor and a memory.

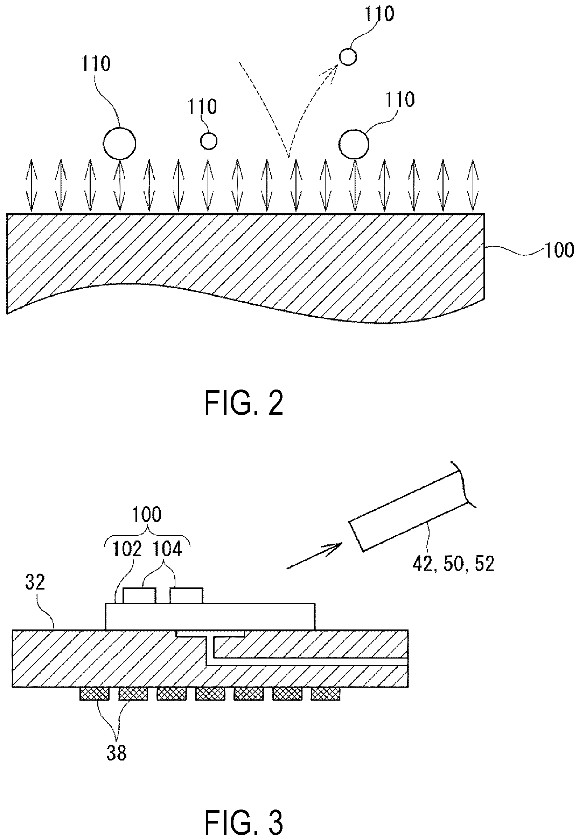

In the following, the reasons why the vibration elements 38, the transport mechanism 42, and the recovery mechanism 50 are provided in the production apparatus 10 are described with reference to FIG. 2. FIG. 2 is a schematic view illustrating the vicinity of the surface of the product 100.

The FFU 20 is provided in the chamber 18, and a large foreign matter is prevented from entering the chamber 18. However, it is difficult to prevent fine foreign matters 110, such as particles, from entering, and the fine foreign matters 110 are present in the chamber 18. In addition, through the operation of the bonding head 12, etc., fine foreign matters 110 may be generated. Conventionally, such foreign matters 110 may gradually precipitate through time, and fall onto and be attached onto the surface of the product 100, that is, the substrate 102 and the chip 104. In the case where such foreign matter 110 is attached to the surface of the product 100, such as the surface of an electrode, etc., the quality of the semiconductor device may deteriorate. In particular, in the case where the electrode of the chip 104 and the electrode of the substrate 102 are bonded under room temperature, when the foreign matters 110 are attached to the respective electrodes, the bonding quality deteriorates significantly.

Therefore, in the embodiment, the vibration elements 38 are provided to more reliably avoid the attachment of the foreign matters 110. According to the above, the vibration elements 38 exert ultrasonic vibration of vertical vibration to the product 100. As a result, the surface of the product 100 is ultrasonically vibrated in the vertical direction. A light-weighted one of the foreign matters 110 that fall down is thrown off due to the ultrasonic vibration and moved toward the upper side of the product 100. In addition, among the foreign matters 110 that fall down, a foreign matter having a certain weight floats on the surface of the product 109. As a result, the foreign matter 110 cannot be attached to the surface of the product 100, and the surface of the product 100 remains clean.

In order to prevent a large amount of the foreign matters 110 that are floating or thrown off from accumulating on the upper side of the product 100, the transport mechanism 42 transports the foreign matters 100 to the outer side of the product 100 in a plan view. In the case of the embodiment, the transport mechanism 42 is the blower nozzle 44. By driving the blower nozzle 44, an air flow is generated in a direction substantially parallel to the surface of the product 100, and the foreign matters 110 are transported. Since the foreign matters 110 of the embodiment are small and light-weighted, the foreign matters 110 can be transported even by using a smaller air flow. The transported foreign matters 110 are collected by the recover mechanism 50. In the case of the embodiment, the recovery mechanism 50 is a suction nozzle 52 that sucks the air in a direction substantially parallel to the surface of the product 100. By sucking and collecting the foreign matters 110 by the suction nozzle 52, a large amount of foreign matters 110 can be prevented from being accumulated on the upper side of the product 100.

As described above, according to the embodiment, the foreign matters 110 can be effectively prevented from being attached to the surface of the product 100. As a result, the quality of the product 100 can remain high. It is noted that the configuration having been described so far is merely an example. If the holding device 30 has the stage 32 on which the product 100 is mounted and the vibration elements 38 applying ultrasonic vibration to the surface of the product 100, other configurations may also be changed.

For example, it may also be that only one vibration element 38 is provided, instead of multiple vibration elements. In addition, instead of being provided on the bottom surface of the stage 32, the vibration element 38 may also be provided in the inside or a side surface of the stage 32, etc., or in other places. In addition, instead of vibrating at a single frequency, the vibration element 38 may also vibrate at multiple frequencies. For example, it may also be that, among the vibration elements 38, some of the vibration elements 38 vibrate at a first frequency, and other vibration elements 38 vibrate at a second frequency. In addition, the levels of the ultrasonic vibration output by the vibration elements 38 may be the same or different from each other. For example, the output levels of the respective vibration elements 38 may be different, so that the substantially central part in the product 100 vibrates at a stronger level than that of the peripheral part.

In addition, the configurations of the transport mechanism 42 and the recovery mechanism 50 may also be changed as appropriate. For example, it may also be that the blower nozzle 44 is not provided, only the suction nozzle 52 is provided, and the suction nozzle 52 is used as the transport mechanism 42 and the recovery mechanism 50. That is, even if the blower nozzle 44 is omitted, as long as the suction nozzle 52 is provided, an air flow toward the suction nozzle 52 is formed, and the foreign matter 110 is transported by the air flow. In addition, the blower nozzle 44 needs not be parallel to the surface of the product 100. As shown in FIG. 3, the blower nozzle 44 may also be provided to be inclined with respect to the surface of the product 100 on the obliquely upper side of the product 100.

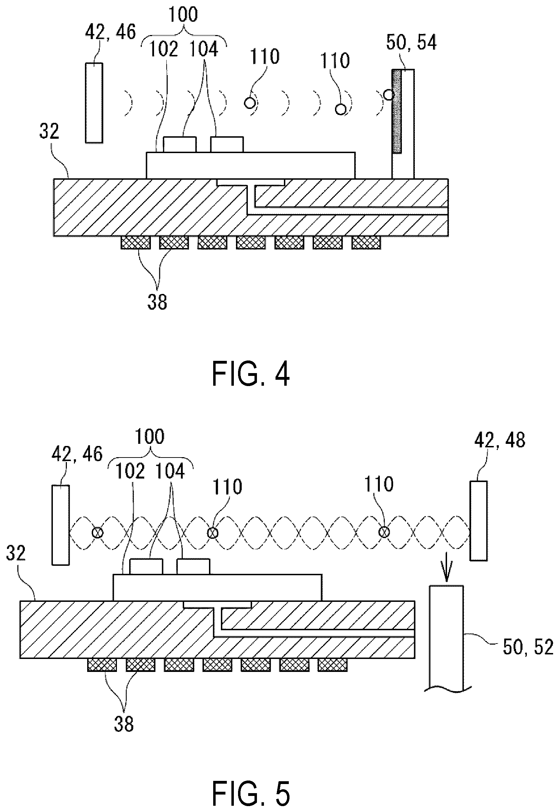

In addition, the transport mechanism 42 may also transport the foreign matters 110 by using sound waves, instead of using air flow. For example, as shown in FIG. 4, the transport mechanism 42 may also have an ultrasonic source 46 provided on a side of the product 100. In such case, the ultrasonic source 46 may output traveling waves of sound waves traveling in a direction substantially parallel to the surface of the product 100. With the sound waves, the foreign matters 110 are transported toward the traveling direction of the sound waves.

Also, as another mode, as shown in FIG. 5, the transport mechanism 42 may also transport the foreign matter 110 by using a standing wave field. In such case, the transport mechanism 42 has the ultrasonic source 46 provided on a side of the product 100 and a reflective plate 48 provided on a side opposite to the ultrasonic source 46 by sandwiching the product 100. The ultrasonic waves output from the ultrasonic source 46 are reflected by the reflective plate 48. Accordingly, the standing waves of ultrasonic waves are formed between the ultrasonic source 46 and the reflective plate 48. In the standing wave field, the foreign matter 110 is attracted to the node of the standing wave and floats. In such state, when the frequency of the ultrasonic source 46 changes, the location of the node of the standing wave changes, and the foreign matter 110 can be transported in a sound axis direction, that is, a direction substantially parallel to the surface of the product 100. In addition, by forming such standing wave field, the falling foreign matters 110 can be more reliably secured, so the foreign matters 110 can be more reliably prevented from being attached to the surface of the product 100.

In addition, the recovery mechanism 50 is not limited to the suction nozzle 52, and may also be an adhesive body 54, as shown in FIG. 4. The adhesive body 54 has an adhesive layer that captures and holds the foreign matters 110 on the surface thereof. By providing the adhesive body 54 on the downstream side in the transport direction of the foreign matters 110, the foreign matters 110 transported by the transport mechanism 42 can be captured, and such foreign matters 110 can be prevented from scattering again in the chamber 18. Also, as another mode, the recovery mechanism 50 may also collect the foreign matters 110 by using the Coulomb force. For example, as the recovery mechanism 50, an electric dust collector having a discharge electrode and a dust collection electrode are disposed on the downstream side of the transport direction.

Meanwhile, the vibration element 38 may be driven continuously during the operation of the production apparatus 10, and may also be driven intermittently in accordance with the progress of the mounting process of the chip 104. By continuously driving the vibration element 38, the foreign matter 110 can be reliably prevented from being attached to the surface of the product 100.

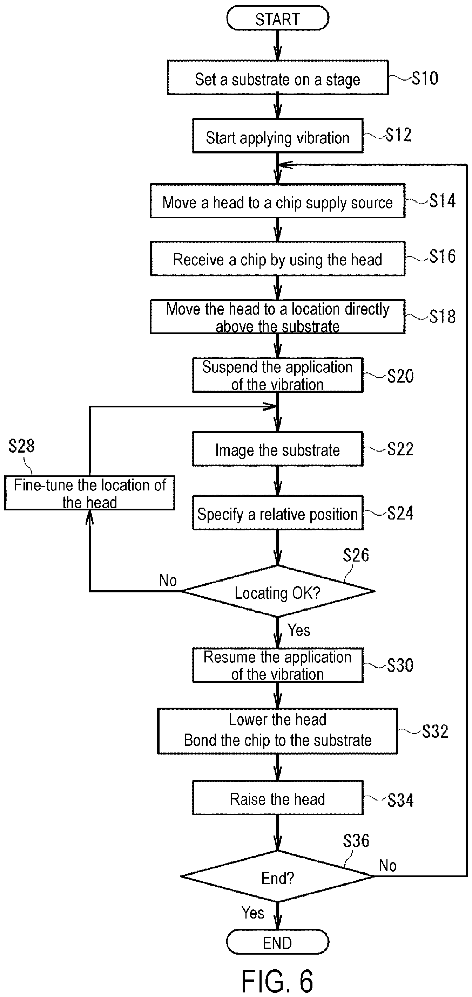

In addition, as another mode, during the execution of the locating process for locating the bonding head 12 with respect to the substrate 102, the vibration element 38 may be temporarily stopped. Such process will be described in detail with reference to the flowchart of FIG. 6. FIG. 6 is a flowchart illustrating an example of a production process of a semiconductor device.

At the time of producing the product 100, that is, the semiconductor device, firstly, the substrate 102 is set on the stage 32 (S10). Such setting is usually executed by a dedicated substrate conveyance device. If the substrate 102 is set, the controller 22 starts the driving of the vibration elements 38 and applies ultrasonic vibration to the substrate 102 (S12). Accordingly, sedimentary foreign matters 110 are effectively prevented from being attached to the product 100.

Then, the controller 22 moves the bonding head 12 to a chip supply source (not shown) (S14). The bonding head 12 receives a new chip 104 in the chip supply source (S16). Then, the bonding head 12 moves to a location directly above the substrate 102 (S18). Then, the controller 22 temporarily suspends the driving of the vibration elements 38 (S20), and then executes the locating process of the bonding head 12 (S22 to S28).

That is, the controller 20 images the substrate 102 by using the locating camera 16 (S22) in a state in which the bonding head 12 is arranged to be stationary at the location directly above the substrate 102. Based on the obtained image, the controller 22 specifies a relative location of the bonding head 12 with respect to the substrate 102 (S24), and determines whether the bonding head 12 is appropriately located based on the relative location (S26). In the case where the relative location is inappropriate, the location of the bonding head 12 is fine-tuned (S28), and the flow returns to Step S22. In the case where the relative location is appropriate (Yes in S26), the controller 22 resumes the driving of the vibration element 38 (S30).

In this way, during the locating process (Steps S22 to S28), by temporarily stopping the vibration elements 38, the locating accuracy can be facilitated. In addition, during the locating period, the bonding head 12 does not move, or, even if the bonding head 12 moves, the bonding head 12 moves at a low speed for a short period of time. Therefore, during the locating period, it can be said that the foreign matters 110 hardly fly up and be attach to the surface of the product 100. Therefore, during the locating period, by temporarily stopping the driving of the vibration elements 38, the locating accuracy of the bonding head 12 can be facilitated, while the risk of foreign matter attachment to the product 100 can be suppressed to be low.

If the bonding head 12 can be located at an appropriate location, in a state of driving the vibration elements 38, the controller 22 lowers the bonding head 12 and brings the chip 104 into contact with the substrate 102 (S32). If the chip 104 is bonded to the substrate 102 through such contact, the controller 22 raises the bonding head 12 (S34). Then, the same process repeats until the required number of chips 104 can be bonded.

The above processing flow is merely an example, and may be changed as appropriate when necessary. For example, in the above embodiment, during the locating process of the bonding head 12, the driving of the vibration elements 38 is temporarily stopped. However, in the case where the movement of the product 100 is not desired, the driving of the vibration elements 38 may also be temporarily stopped at another timing. For example, in FIG. 6, the step in which the chip 104 is brought into contact with the substrate 102 is shown by using one single step S32. However, in reality, in order to prevent the collision between the chip 104 and the substrate 102, the bonding head 12 is lowered in two steps. That is, the bonding head 12 lowers at a high speed to a predetermined reference height where the chip 104 and the substrate 102 are close, and, upon reaching the reference height, the bonding head 12 lowers at a low speed while confirming whether the chip 104 lands on the substrate 102. It may be that the product 10 is to be stationary during the period in which the bonding head 12 lowers while confirming whether the chip 104 lands (that is, immediately before landing) and immediately after landing. Therefore, during the period immediately before and after landing, the driving of the vibration elements 38 may be temporarily stopped.

In addition, after the chip 104 is bonded to the substrate 102, an inspection process that confirms the bonding accuracy may be performed. In such inspection process, the location, etc., of the chip 104 with respect to the substrate 102 is inspected. At the time of inspection, the driving of the vibration elements 38 may be temporarily stopped.

In addition, in the description having been made so far, an example of the production apparatus bonding the chip 104 to the substrate 102 is described as an instance. However, the holding device 30 is not limited to the production apparatus 10 and may also be assembled to another apparatus. For example, the holding device 30 may also be used as a device for holding a glass substrate during the process of producing a flat panel display. In addition, the holding device 30 is not limited to the production apparatus 10, and may also be assembled to another apparatus, such as an inspection apparatus inspecting the product quality of other devices. In addition, the holding device 30 may also be used alone, instead of being assembled to other apparatuses. For example, the holding device 30 may also be used alone in order to temporarily store the product. In addition, the product held by the holding device 30 is not particularly limited, and may also be a product other than a semiconductor device or a flat panel display.

### [Reference Signs List]

10: Production apparatus; 12: Bonding head; 14: Bonding tool; 16: Locating camera; 18: Chamber; 22: Controller; 30: Holding device; 32: Stage; 34: Suction hole; 36: Suction port; 38: Vibration element; 42: Transport mechanism; 44: Blower nozzle; 46: Ultrasonic source; 48: Reflective plate; 50: Recovery mechanism; 52: Suction nozzle; 54: Adhesive body; 100: Product; 102: Substrate; 104: Chip; 110: Foreign matter.

## Claims

1. A product holding apparatus, comprising:
a stage, on which a product is mounted;
a vibration source, applying ultrasonic vibration to the product mounted on the stage and causing a falling foreign matter to float at a location away from a surface of the product.

2. The product holding apparatus as claimed in claim 1, further comprising:
a transport mechanism, transporting the floating foreign matter to a location on an outer side of the product in a plan view.

3. The product holding apparatus as claimed in claim 2,
wherein the transport mechanism comprises at least one of a blower for compressing air and a suction machine for sucking air.

4. The product holding apparatus as claimed in claim 2,
wherein the transport mechanism comprises an ultrasonic source outputting traveling waves of ultrasonic waves in a direction substantially parallel to the surface of the product.

5. The product holding apparatus as claimed in claim 2,
wherein the transport mechanism comprises an ultrasonic source and a reflective plate arranged to face each other by sandwiching the product, and
the transport mechanism forms a standing wave field by using ultrasonic waves formed between the ultrasonic source and the reflective plate and transports the foreign matter in the standing wave field by moving a node of a sound pressure.

6. The product holding apparatus as claimed in claim 2, further comprising:
a recovery mechanism, collecting the foreign matter transported to the outer side of the product by using the movement mechanism.

7. The product holding apparatus as claimed in claim 6,
wherein the recovery mechanism comprises at least one of a suction machine, an adhesive body, and an electric dust collector, the suction machine sucks and collects the foreign matter transported to the outer side of the product by using the movement mechanism, the adhesive body adheres and holds the foreign matter, and the electric dust collector collects the foreign matter by using a Coulomb force.

8. A product holding method, in which, in a state in which a product is mounted on a stage, ultrasonic vibration is applied to the product to cause a falling foreign matter to float at a location away from a surface of the product.

9. A semiconductor device production apparatus, mounting a chip on a substrate to produce a semiconductor device, the semiconductor device production apparatus comprising:
the product holding device as claimed in any one of claims 1 to 8,
wherein at least one of the substrate and the chip is held, as the product, by using the product holding device.

10. The semiconductor device production apparatus as claimed in claim 9, further comprising:
a controller,
wherein the controller intermittently drives the vibration element in accordance with a progress of a mounting process of the chip.

11. The semiconductor device production apparatus as claimed in claim 10,
wherein the controller temporarily stops driving of the vibration element at at least one of a locating timing of adjusting a location of a mounting head with respect to the substrate, a timing immediately before and after a chip held by the mounting head lands on the substrate, and a timing of confirming locating accuracy of the chip that is mounted.
